Europäisches Patentamt

European Patent Office

Office européen des brevets

(19)

(11) **EP 1 517 188 A2**

(12) **EUROPEAN PATENT APPLICATION**

(43) Date of publication:
    23.03.2005 Bulletin 2005/12

(51) Int Cl.⁷: **G03F 7/20**

(21) Application number: **04255638.1**

(22) Date of filing: **16.09.2004**

(84) Designated Contracting States:
    **AT BE BG CH CY CZ DE DK EE ES FI FR GB GR HU IE IT LI LU MC NL PL PT RO SE SI SK TR**
    Designated Extension States:
    **AL HR LT LV MK**

(30) Priority: **22.09.2003 EP 03255906**
                **03.10.2003 US 677242**

(71) Applicants:
    • **ASML Netherlands B.V.**
      **5504 DR Veldhoven (NL)**
    • **ASML Holdings N.V.**
      **5504 DR Veldhoven (NL)**

(72) Inventors:
    • **Bleeker, Arno Jan**
      **5563 CE Westerhoven (NL)**
    • **Franken, Dominicus Jacobus Petrus Adrianus**
      **5508 JA Veldhoven (NL)**
    • **Kochersperger, Peter C.**
      **Easton, CT (US)**
    • **Troost, Kars Zeger**
      **5583 XP Waalre (NL)**

(74) Representative: **Leeming, John Gerard**
    **J.A. Kemp & Co.,**
    **14 South Square,**
    **Gray's Inn**
    **London WC1R 5JJ (GB)**

(54) **Lithographic apparatus and device manufacturing method**

(57)    One or more programmable patterning means are mounted to a mounting plate via height adjustment structures that enable the flatness of the active surfaces of the patterning means to be controlled. The height adjustment structures may comprise an array of piezoelectric actuators or screws. Alternatively, the backside of the patterning means may be polished to optical flatness and bonded by crystal bonding to an optically flat surface of a rigid mounting body.

FIG. 9

EP 1 517 188 A2

**Description**

Field

The present invention relates to a lithographic apparatus and a device manufacturing method.

Background

A lithographic apparatus is a machine that applies a desired pattern onto a target portion of a substrate. Lithographic apparatus can be used, for example, in the manufacture of integrated circuits (ICs), flat panel displays and other devices involving fine structures. In a conventional lithographic apparatus, a patterning array, which is alternatively referred to as a mask or a reticle, may be used to generate a circuit pattern corresponding to an individual layer of the IC (or other device), and this pattern can be imaged onto a target portion (e.g. comprising part of, one or several dies) on a substrate (e.g. a silicon wafer or glass plate) that has a layer of radiation-sensitive material (resist). Instead of a mask, the patterning array may comprise an array of individually controllable elements which serve to generate the circuit pattern.

In general, a single substrate will contain a network of adjacent target portions that are successively exposed. Known lithographic apparatus include so-called steppers, in which each target portion is irradiated by exposing an entire pattern onto the target portion in one go, and so-called scanners, in which each target portion is irradiated by scanning the pattern through the projection beam in a given direction (the "scanning"-direction) while synchronously scanning the substrate parallel or anti-parallel to this direction.

In conventional lithography apparatus using masks, stringent requirements are imposed on the global flatness of the mask to prevent telecentricity errors at the substrate. The relatively large demagnification M, e.g. a reduction by a factor of 200-400, used in maskless lithography apparatus, that is a lithography apparatus using a patterning array, exacerbates the problem. The global unflatness U, i.e. unflatness over a period of about 10 or more mirrors, translates into a telecentricity error TE at wafer level according to the formula:

$$TE = 2 \cdot M \cdot U \qquad (1)$$

so a global unflatness of 40μrad, typical for a patterning array, gives a telecentricity error of 16-32mrad compared to a normal specification of 10mrad total, including lens and other mechanical contributions.

Furthermore, as maskless lithography capabilities increase, the tolerance for error in an exposure decreases. Among the errors present in an exposure are optical aberrations in the exposure optics, which are typically caused by manufacturing and assembly tolerance in the exposure optics. Aberrations can result in total focus deviation, among other exposure errors. Total focus deviation results when a focal length of the exposure optics is not identical in all areas of the exposure beam. In this case, a flat patterning array assembly does not focus onto a flat plane at the image or wafer plane. When the optics are changed to correct for the error, movement of the optics components requires great precision. Otherwise, difficulties arise that can introduce additional error into the system. What is needed is a system and method for reducing aberrations without introducing additional error into the maskless system.

Summary

It is desirable to provide an arrangement for mounting one or more patterning arrays such that unflatness of the patterning arrays can be reduced.

According to an aspect of the invention, there is provided a lithographic apparatus comprising:

- an illumination system for supplying a projection beam of radiation;
- a patterning array of individually controllable elements serving to impart the projection beam with a pattern in its cross-section;
- a mounting plate on which said patterning array is mounted;
- a height adjustment structure for locally adjusting the height of the active surface of said patterning array;
- a substrate table for supporting a substrate; and
- a projection system for projecting the patterned beam onto a target portion of the substrate.

According to another aspect of the invention, there is provided a lithographic apparatus comprising:

- an illumination system for supplying a projection beam of radiation;
- a patterning array of individually controllable elements serving to impart the projection beam with a pattern in its cross-section;
- a substrate table for supporting a substrate; and
- a projection system for projecting the patterned beam onto a target portion of the substrate; wherein
- said patterning array comprises a plurality of active elements disposed on a first surface of a substrate, a second surface of said substrate opposite said first substrate being optically flat; and a rigid mounting body having an optically flat surface to which said second surface of said substrate is bonded.

According to a further aspect of the invention there is provided a device manufacturing method comprising the steps of:

- providing a substrate that is at least partially covered by a layer of radiation sensitive material;

- providing a projection beam of radiation using a radiation system;
- using patterning array to endow the first projection beam with a pattern in its cross-section;
- projecting the patterned projection beam of radiation onto a target portion of the layer of radiation-sensitive material, and
- mounting the patterning array to a mounting plate or rigid body in such a manner as to ensure the active surface thereof is flat.

According to a further aspect of the invention, corrections for total focus deviation are made by moving individual patterning arrays in a patterning array assembly. Instead of aligning all patterning arrays so that they define a flat patterning array assembly plane, at least one patterning array has the capability to deviate from the flat plane. In an embodiment, each patterning array in the patterning array assembly occupies a first position. Data is received at the wafer plane (also referred to herein as the image plane) so as to determine a corrective adjustment needed. On the basis of this determination, various patterning arrays in the patterning array assembly move out of the first position into a second position. Each patterning array is moved separately, if at all. This causes the patterning array assembly to deviate from a flat plane.

The movement of an individual patterning array from the first position to the second position can involve tilting, changing elevation, or bending. These changes are effected by an adjuster or set of adjusters attached to each patterning array. In an embodiment, the adjusters change lengths in order to move their respective patterning arrays to the second positions. The adjusters may be actively or passively controlled. Actively controlled adjusters may include, for example, pistons. Passively controlled adjusters may include, for example, screws or bolts whose lengths are manually changed.

After individual patterning arrays have been moved to their second positions, light from an illumination system illuminates the patterning array assembly. The patterning array assembly reflects light through at least one optical system. The light then exposes an object at the image plane.

With the present invention, aberrations such as total focus deviation can be reduced without making high-precision adjustments to lenses in the optical system. Further, correcting aberrations with the patterning arrays allows a less stringent specification for the optics when the system is built.

The term "patterning array of individually controllable elements" as here employed should be broadly interpreted as referring to any means that can be used to endow an incoming radiation beam with a patterned cross-section, so that a desired pattern can be created in a target portion of the substrate; the terms "light valve" and "Spatial Light Modulator" (SLM) can also be used in this context. Examples of such patterning arrays include:

- A programmable mirror array. This may comprise a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate spatial filter, the said undiffracted light can be filtered out of the reflected beam, leaving only the diffracted light to reach the substrate; in this manner, the beam becomes patterned according to the addressing pattern of the matrix-addressable surface. It will be appreciated that, as an alternative, the filter may filter out the diffracted light, leaving the undiffracted light to reach the substrate. An array of diffractive optical MEMS devices can also be used in a corresponding manner. Each diffractive optical MEMS device is comprised of a plurality of reflective ribbons that can be deformed relative to one another to form a grating that reflects incident light as diffracted light. A further alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the array of individually controllable elements can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference.
- A programmable LCD array. An example of such a construction is given in United States Patent US 5,229,872, which is incorporated herein by reference.

It should be appreciated that where pre-biasing of features, optical proximity correction features, phase variation techniques and multiple exposure techniques are used, for example, the pattern "displayed" on the array of individually controllable elements may differ substantially from the pattern eventually transferred to a layer of or on the substrate. Similarly, the pattern eventually generated on the substrate may not correspond to the pattern formed at any one instant on the array of individually controllable elements. This may be the case in an arrangement in which the eventual pattern formed on each part of the substrate is built up over a given period of time or a given number of exposures during which the pattern on the array of individually controllable elements and/or the relative position of the substrate changes.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat panel displays, thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist) or a metrology or inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of 408, 355, 365, 248, 193, 157 or 126 nm) and extreme ultra-violet (EUV) radiation (e.g. having a wavelength in the range of 5-20 nm), as well as particle beams, such as ion beams or electron beams.

The term "projection system" used herein should be broadly interpreted as encompassing various types of projection system, including refractive optical systems, reflective optical systems, and catadioptric optical systems, as appropriate for example for the exposure radiation being used, or for other factors such as the use of an immersion fluid or the use of a vacuum. Any use of the term "lens" herein may be considered as synonymous with the more general term "projection system".

The illumination system may also encompass various types of optical components, including refractive, reflective, and catadioptric optical components for directing, shaping, or controlling the projection beam of radiation, and such components may also be referred to below, collectively or singularly, as a "lens".

The lithographic apparatus may be of a type having two (dual stage) or more substrate tables. In such "multiple stage" machines the additional tables may be used in parallel, or preparatory steps may be carried out on one or more tables while one or more other tables are being used for exposure.

The lithographic apparatus may also be of a type wherein the substrate is immersed in a liquid having a relatively high refractive index, e.g. water, so as to fill a space between the final element of the projection system and the substrate. Immersion liquids may also be applied to other spaces in the lithographic apparatus, for example, between the array of individually controllable elements and the first element of the projection system. Immersion techniques are well known in the art for increasing the numerical aperture of projection systems.

Embodiments of the invention will now be described, by way of example only, with reference to the accompanying schematic drawings in which corresponding reference symbols indicate corresponding parts, and in which:

- Figure 1 depicts a lithographic apparatus according to an embodiment of the invention;
- Figure 2 depicts a patterning array and mounting assembly in a first embodiment of the invention;
- Figure 3 depicts a patterning array and mounting assembly in a variant of the first embodiment of the invention;
- Figure 4 depicts a patterning array and mounting assembly in a second variant of the first embodiment of the invention;
- Figure 5 depicts a patterning array and mounting assembly in a second embodiment of the invention;
- Figure 6 is a flow diagram of a manufacturing process for producing a patterning array and mounting assembly of the second embodiment of the invention;
- Figure 7 is a flow diagram of a variant manufacturing process for producing a patterning array and mounting assembly of the second embodiment of the invention;
- Figure 8 is block diagram of a maskless lithography system having reflective patterning arrays, according to embodiments of the present invention.
- Figure 9 is a block diagram of a maskless lithography system having transmission patterning arrays, according to embodiments of the present invention.
- Figure 10 is an illustration of a patterning array, according to an embodiment of the present invention.
- Figure 11 is an illustration of further details of the patterning array in Figure 10.
- Figure 12 is an illustration of an assembly according to embodiments of the present invention.
- Figure 13 is a flowchart of a method according to an embodiment of the present invention.
- Figure 14 is another flowchart of a method according to an embodiment of the present invention.
- Figure 15 is an illustration of a patterning array having a set of adjusters, according to an embodiment of the present invention.
- Figure 16A is a frontal illustration of a patterning array assembly, according to an embodiment of the present invention.

- Figure 16B is a cross-sectional illustration of a patterning array assembly, according to an embodiment of the present invention.
- Figure 17A is a frontal illustration of a patterning array assembly, according to an embodiment of the present invention.
- Figure 17B is a cross-sectional illustration of a patterning array assembly, according to an embodiment of the present invention.
- Figure 18A is a frontal illustration of a patterning array assembly, according to an embodiment of the present invention.
- Figure 18B is a cross-sectional illustration of a patterning array assembly, according to an embodiment of the present invention.

EMBODIMENTS

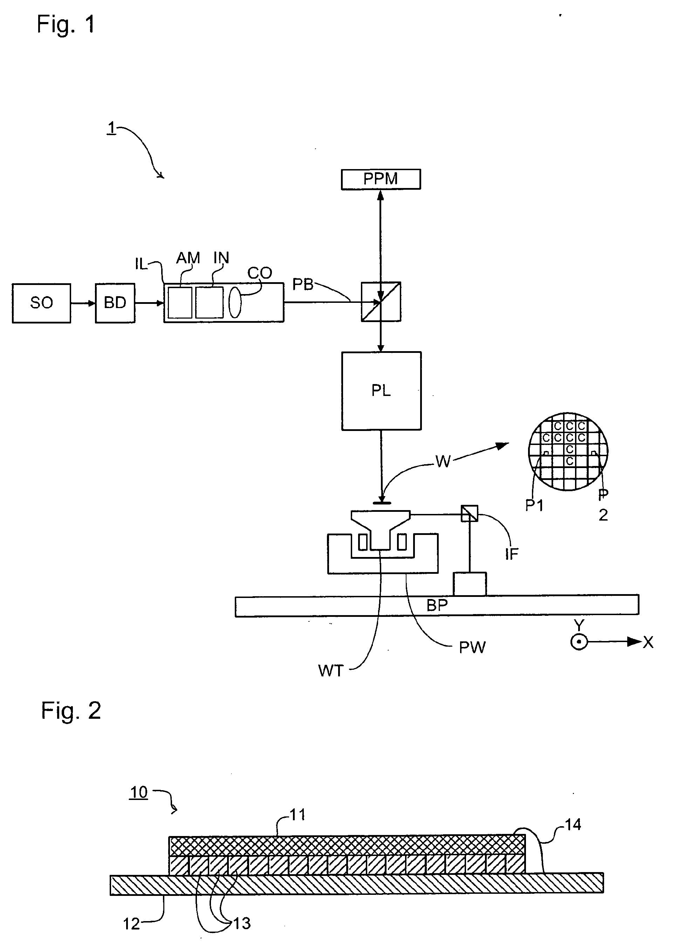

Figure 1 schematically depicts a lithographic projection apparatus according to a particular embodiment of the invention. The apparatus comprises:

- an illumination system (illuminator) IL for providing a projection beam PB of radiation (e.g. UV radiation);
- an array of individually controllable elements PPM (e.g. a programmable mirror array) for applying a pattern to the projection beam; in general the position of the array of individually controllable elements will be fixed relative to item PL; however it may instead be connected to a positioning means for accurately positioning it with respect to item PL;
- a substrate table (e.g. a wafer table) WT for supporting a substrate (e.g. a resist-coated wafer) W, and connected to positioning means PW for accurately positioning the substrate with respect to item PL; and
- a projection system ("lens") PL for imaging a pattern imparted to the projection beam PB by the array of individually controllable elements PPM onto a target portion C (e.g. comprising one or more dies) of the substrate W; the projection system may image the array of individually controllable elements onto the substrate; alternatively, the projection system may image secondary sources for which the elements of the array of individually controllable elements act as shutters; the projection system may also comprise an array of focusing elements such as a micro lens array (known as an MLA) or a Fresnel lens array, e.g. to form the secondary sources and to image microspots onto the substrate.

As here depicted, the apparatus is of a reflective type (i.e. has a reflective array of individually controllable elements). However, in general, it may also be of a transmissive type, for example (*i.e.* with a transmissive array of individually controllable elements).

The illuminator IL receives a beam of radiation from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising for example suitable directing mirrors and/or a beam expander. In other cases the source may be integral part of the apparatus, for example when the source is a mercury lamp. The source SO and the illuminator IL, together with the beam delivery system BD if required, may be referred to as a radiation system.

The illuminator IL may comprise adjusting means AM for adjusting the angular intensity distribution of the beam. Generally, at least the outer and/or inner radial extent (commonly referred to as σ-outer and σ-inner, respectively) of the intensity distribution in a pupil plane of the illuminator can be adjusted. In addition, the illuminator IL generally comprises various other components, such as an integrator IN and a condenser CO. The illuminator provides a conditioned beam of radiation, referred to as the projection beam PB, having a desired uniformity and intensity distribution in its cross-section.

The beam PB subsequently intercepts the array of individually controllable elements PPM. Having been reflected by the array of individually controllable elements PPM, the beam PB passes through the projection system PL, which focuses the beam PB onto a target portion C of the substrate W. With the aid of the positioning means PW (and interferometric measuring means IF), the substrate table WT can be moved accurately, e.g. so as to position different target portions C in the path of the beam PB. Where used, the positioning means for the array of individually controllable elements can be used to accurately correct the position of the array of individually controllable elements PPM with respect to the path of the beam PB, e.g. during a scan. In general, movement of the object table WT is realized with the aid of a long-stroke module (course positioning) and a short-stroke module (fine positioning), which are not explicitly depicted in Figure 1. A similar system may also be used to position the array of individually controllable elements. It will be appreciated that the projection beam may alternatively/additionally be moveable while the object table and/or the array of individually controllable elements may have a fixed position to provide the required relative movement. As a further alternative, that may be especially applicable in the manufacture of flat panel displays, the position of the substrate table and the projection system may be fixed and the substrate may be arranged to be moved relative to the substrate table. For example, the substrate table may be provided with a system for scanning the substrate across it at a substantially constant velocity.

Although the lithography apparatus according to the invention is herein described as being for exposing a resist on a substrate, it will be appreciated that the invention is not limited to this use and the apparatus may be used to project a patterned projection beam for use in resistless lithography.

The depicted apparatus can be used in four preferred modes:

1. Step mode: the array of individually controllable elements imparts an entire pattern to the projection beam, which is projected onto a target portion C in one go (i.e. a single static exposure). The substrate table WT is then shifted in the X and/or Y direction so that a different target portion C can be exposed. In step mode, the maximum size of the exposure field limits the size of the target portion C imaged in a single static exposure.

2. Scan mode: the array of individually controllable elements is movable in a given direction (the so-called "scan direction", e.g. the Y direction) with a speed v, so that the projection beam PB is caused to scan over the array of individually controllable elements; concurrently, the substrate table WT is simultaneously moved in the same or opposite direction at a speed V = Mv, in which M is the magnification of the lens PL. In scan mode, the maximum size of the exposure field limits the width (in the non-scanning direction) of the target portion in a single dynamic exposure, whereas the length of the scanning motion determines the height (in the scanning direction) of the target portion.

3. Pulse mode: the array of individually controllable elements is kept essentially stationary and the entire pattern is projected onto a target portion C of the substrate using a pulsed radiation source. The substrate table WT is moved with an essentially constant speed such that the projection beam PB is caused to scan a line across the substrate W. The pattern on the array of individually controllable elements is updated as required between pulses of the radiation system and the pulses are timed such that successive target portions C are exposed at the required locations on the substrate. Consequently, the projection beam can scan across the substrate W to expose the complete pattern for a strip of the substrate. The process is repeated until the complete substrate has been exposed line by line.

4. Continuous scan mode: essentially the same as pulse mode except that a substantially constant radiation source is used and the pattern on the array of individually controllable elements is updated as the projection beam scans across the substrate and exposes it.

Combinations and/or variations on the above described modes of use or entirely different modes of use may also be employed.

As shown in Figure 2, the patterning array 11 is mounted on a rigid plate 12 to form a patterning array assembly 10. This assembly is mounted in the apparatus 1 by, if required, a positioning means (not shown). Electrical connections to the patterning array can be made via the rigid member or plate 12 and wires 14. Between the patterning array 11 and the rigid plate 12 is an array of piezoelectric elements 13 that can, when appropriately activated, distort the patterning array 11 so as to correct the unflatness thereof to within the desired specification. The piezo-electric elements may be also be integrated into either the patterning array or the mounting plate. The array of piezoelectric elements 13 may be 1-dimensional if the patterning array is linear but is preferably 2-dimensional. The spacing of the array is in general much greater than the pitch of the pixels of the patterning array 11 - its spacing is chosen according to the spatial frequency of the expected unflatness of the patterning array 11.

The piezo-electric elements are preferably arranged so that actuation thereof alters their length in the direction perpendicular to the nominal plane of the active surface of the patterning array so as to directly distort the patterning array. However, it is also possible to use piezoelectric actuators that exert forces in the plane of the patterning array so as to alter its shape by control of tension and/or compression forces within it.

Appropriate control signals to effect the required correction of the unflatness of the patterning array can be determined during calibration, or recalibration, of the apparatus and applied whenever the apparatus is operating.

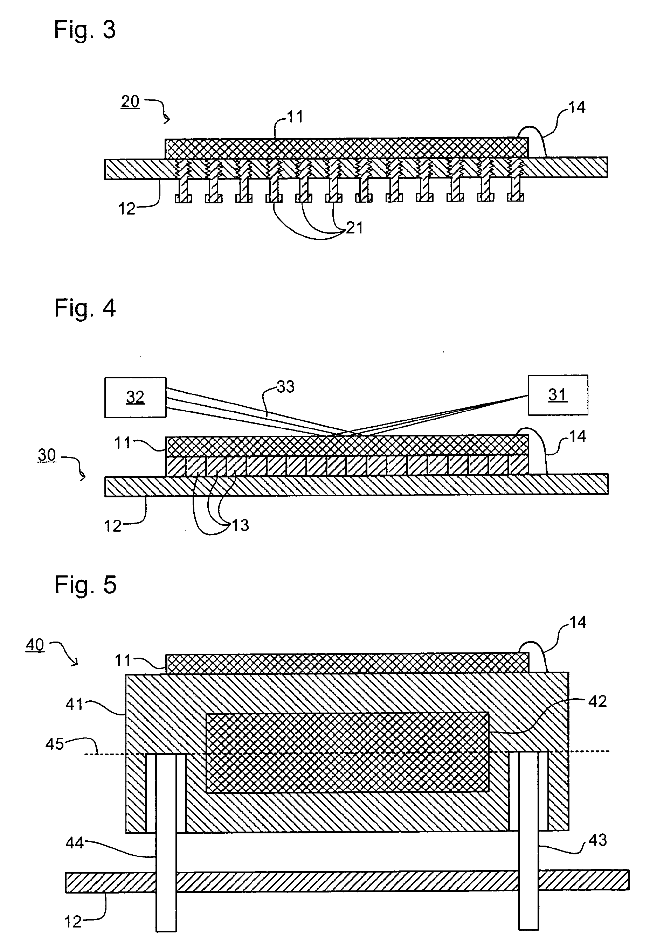

A variant of the patterning array of the first embodiment is shown in Figure 3. In this assembly 20, the piezoelectric actuators are replaced by an array of screws or bolts 21 provided in threaded through-holes in the rigid plate 12 and bearing against the backside of the patterning array so that they can be adjusted to alter the shape of the patterning array 11. Again, adjustment of the screws or bolts is performed during calibration, or recalibration, of the apparatus but is then set without need for further action.

Figure 4 shows a second variant in which active control of the shape of the patterning array is provided. A level sensor system which comprises beam source 31 to direct a beam 33 at an acute angle to the patterning array 11 so that it is reflected to sensor 32, detects unflatness of the patterning array by virtue of the position at which the beam 33 is incident on sensor 32. The beam 33 has a footprint larger than a pixel of the patterning array so that the overall flatness of the patterning array is detected, rather than the angle of an individual mirror, in the case where the patterning array is a deformable mirror device. When using such a device, it is also preferred to make the measurements of flatness during the period between pulses of the radiation source LA , when the mirrors of the device are in the rest state.

The results of the measurement of the flatness of the patterning array are used in a feedback loop to control the piezoelectric actuators so that the patterning array achieves the desired flatness.

Of course, other passive or active actuators may be used to adjust the flatness of the patterning array. For example, the patterning array may be mounted on a plurality of rods of a material with a reasonably high thermal coefficient of expansion, a heating coil is wound about each rod and the coils are selectively energized to cause selective heating and hence selective expansion of the rods. Thermal elements mounted in or on the mounting plate may also be used, as can actuators operating on pneumatic, magnetic or hydraulic principles. Furthermore, the patterning array may be mounted on the ends of a plurality of rods or pins, the other ends of which are interconnected by a plurality of actuators of any of the above mentioned types. By controlling the forces acting between the ends of the rods, local bending moments can be induced in the patterning array to improve its flatness.

A further embodiment of the invention is the same as that described above, save in the mounting of the patterning array 11, as described below. This aspect of the invention represents an alternative solution to the problem addressed by the invention. Rather than providing a height adjustment structure for adjusting the flatness of the patterning means, its flatness is assured by polishing its rear surface to optical flatness, e.g. less than about 0.1 μm, and then mounting it on a relatively rigid body, that has also been ground to the same degree of flatness. The rigid body needs to be sufficiently rigid to assure the flatness is maintained during use of the apparatus.

The rigid body can be mounted via a fixed or active mount that is able to correct the global tilt of the patterning means. Preferably, the rigid mounting body is mounted along its neutral line so that the patterning means is not distorted in the event of thermal expansion or contraction of the mounting body.

Ideally, the bonding between the substrate of the programmable patterning means and the holding body is as strong as possible. A preferred bonding technique is direct crystal bonding ("ansprengen") achieved by ensuring that the surfaces to be bonded are completely clean and flat before being brought into contact such that the two crystal structures bond.

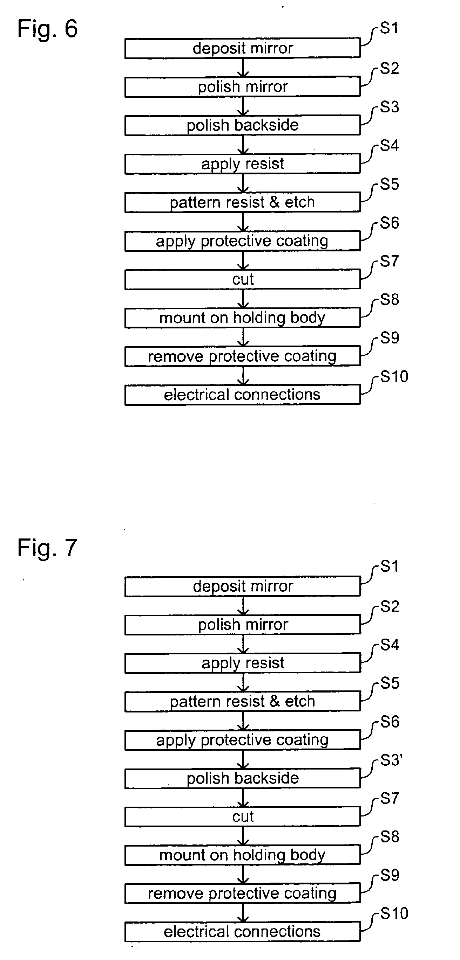

In this embodiment, as shown in Figure 5, the desired flatness of the patterning array is achieved by polishing the backside of the patterning array 11 to optical flatness during its manufacture and bonding it to a similarly polished surface of a rigid body 41. To enable direct crystal bonding (ansprengen) between the patterning array and the rigid body, the surface roughness of the two surfaces should be less than 0.1 μm. The rigid body 41 may also carry control or power supply electronic circuitry 42 for the patterning array 11. The circuitry may be provided on the side or bottom of the rigid body 41. The rigid body is mounted to the main plate of the patterning array assembly 40 by actuators or pivots 43, 44, preferably three in number, which allow its global tilt to be set or controlled as required. Two examples of manufacturing processes, for producing a patterning array with a polished backside and bonding it to a polished rigid body, are shown as flow diagrams in Figures 6 and 7.

As an alternative to direct crystal bonding, the patterning array 11 may be bonded to the rigid body by a so-called "verennest". A verennest comprises a large number of small flexible elements, usually identical, and usually of metal. By the use of many elements, a uniformly distributed force can be achieved regardless of local unflatness or thickness variation of the object to be clamped. Thus a plurality of small individual spring members, each with a relatively small spring force are used around the edge of the patterning array to clamp it to the rigid body. Three stops may be provided to limit in plane movements of the patterning array.

A further alternative, is to glue the patterning array using a glue containing glass spheres of carefully calibrated diameter. Preferably, the glue is applied in a large number of small spots. In this way the thickness of the glue layer can be controller to a very constant value, e.g. 10μm ± 1 μm.

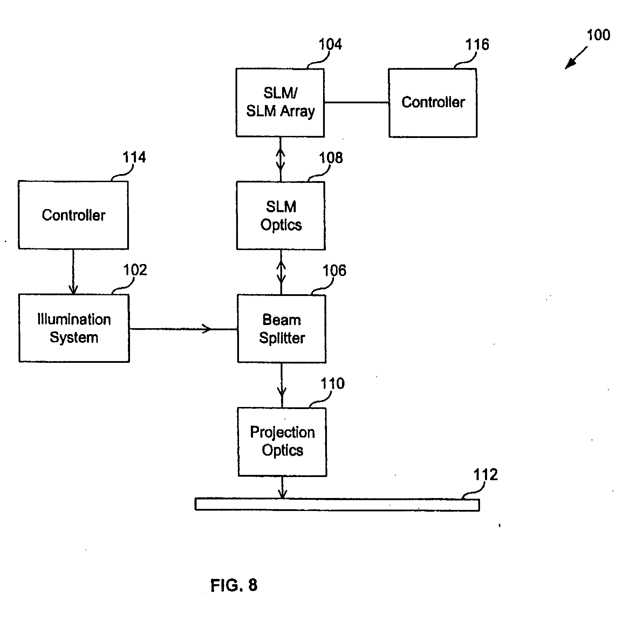

Figure 8 shows a maskless lithography system 100 according to an embodiment of the present invention. System 100 includes an illumination system 102 that transmits light to a reflective patterning array 104 (e.g., a digital micromirror device (DMD), a reflective liquid crystal display (LCD), or the like) via a beam splitter 106 and patterning array optics 108. Patterning array 104 is used to pattern the light in place of a reticle in traditional lithography systems. Patterned light reflected from patterning array 104 is passed through beam splitter 106 and projection optics 110 and written on an object 112 (e.g., a substrate, a semiconductor wafer, a glass substrate for a flat panel display, or the like).

It is to be appreciated that illumination optics can be housed within illumination system 102, as is known in the relevant art. It is also to be appreciated that patterning array optics 108 and projection optics 110 can include any combination of optical elements required to direct light onto desired areas of patterning array 104 and/or object 112, as is known in the relevant art.

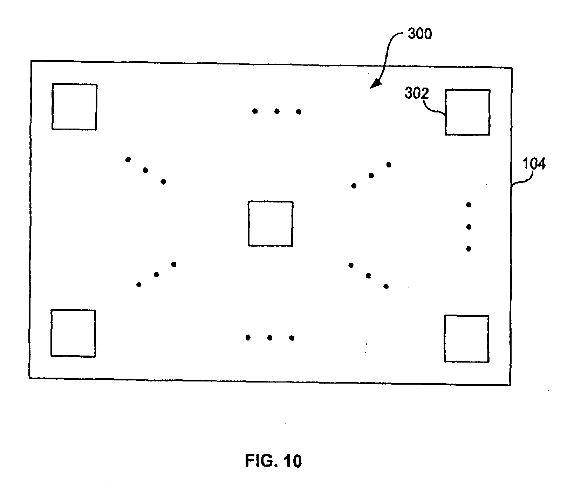

In alternative embodiments, either one or both of illumination system 102 and patterning array 104 can be coupled to or have integral controllers 114 and 116, respectively. Controller 114 can be used to adjust illumination system 102 based on feedback from system 100 or to perform calibration. Controller 116 can also be used for adjustment and/or calibration. Alternatively, controller 116 can be used for switching pixels 302 on patterning array 104 between their discrete states (e.g., between one of their graytone states and the completely dark, or OFF state) (see Figure 10). This can generate a pattern used to expose object 112. Controller 116 can either have integral storage or be coupled to a storage element (not shown) with predetermined information and/or algorithms used to generate the pattern or patterns.

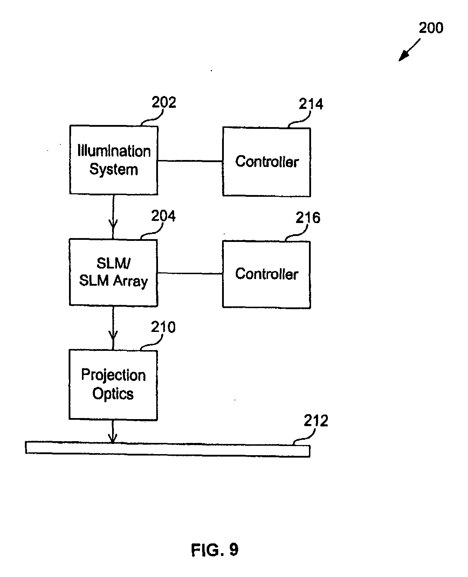

Figure 9 shows a maskless lithography system 200 according to a further embodiment of the present invention. System 200 includes an illumination system 202 that transmits light through a patterning array 204 (e.g., a transmissive LCD, or the like) to pattern the light. The patterned light is transmitted through projection optics 210 to write the pattern on a surface of an object 212. In this embodiment, patterning array 204 is a transmissive patterning array, such as a liquid crystal display, or the like. Similar to above, either one or both of illumination system 202 and patterning array 204 can be coupled to or integral with controllers 214 and 216, respectively. Controllers 214 and 216 can perform similar functions as controller 114 and 116 described above, and as known in the art.

Example patterning arrays that can be used in either of systems 100 or 200 are manufactured by Micronic Laser Systems AB of Sweden and Fraunhofer Institute for Circuits and Systems of Germany.

Merely for convenience, reference will be made only to system 100 below. However, all concepts discussed below can also apply to system 200, as would be known to someone skilled in the relevant arts. Other arrangements or integration of the components and controllers of Figures 8 and 9 will become apparent to one of ordinary skill in the art without departing from the spirit and scope of the present invention.

Figure 10 shows details of an active area 300 of patterning array 104, for example. Active area 300 includes an n x m array of pixels 302 (represented by squares and series of dots in the figure). Pixels 302 can be mirrors on a DMD or locations on an LCD. By adjusting the physical characteristics of pixels 302, they can be seen as being in one of their states. Digital or analog input signals based on a desired pattern are used to switch states of the various pixels 302. In some embodiments, an actual pattern being written to object 112 can be detected and a determination can be made whether the pattern is outside an acceptable tolerance. If so, controller 116 can be used to generate analog or digital control signals in real time to fine-tune (e.g., calibrate, adjust, etc.) the pattern being generated by patterning array 104.

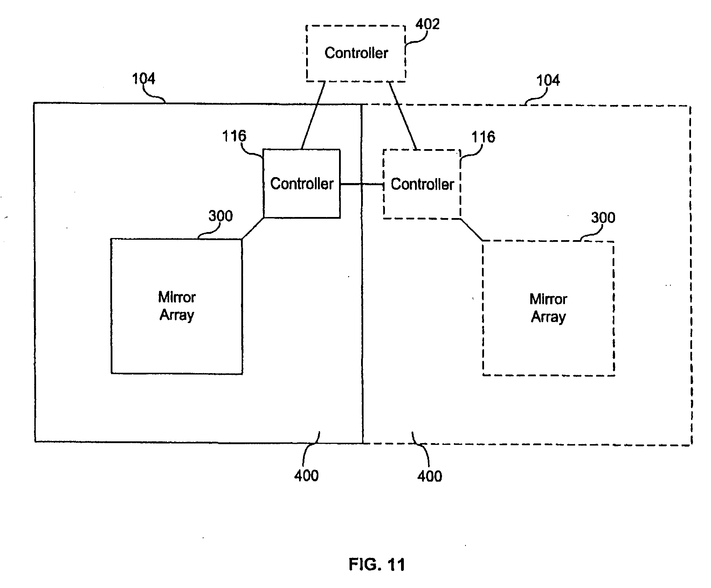

Figure 11 shows further details of patterning array 104. Patterning array 104 can include an inactive packaging 400 surrounding active area (e.g., mirror array) 300. Also, in alternative embodiments, a main controller 402 can be coupled to each patterning array controller 116 to monitor and control an array of patterning arrays. The dashed lines in Figure 11 represent a second patterning array in an array of patterning arrays. More than one patterning array can be added to the array to suit the implementation design. As discussed below, adjacent patterning arrays can be offset or staggered with respect to each other in other embodiments.

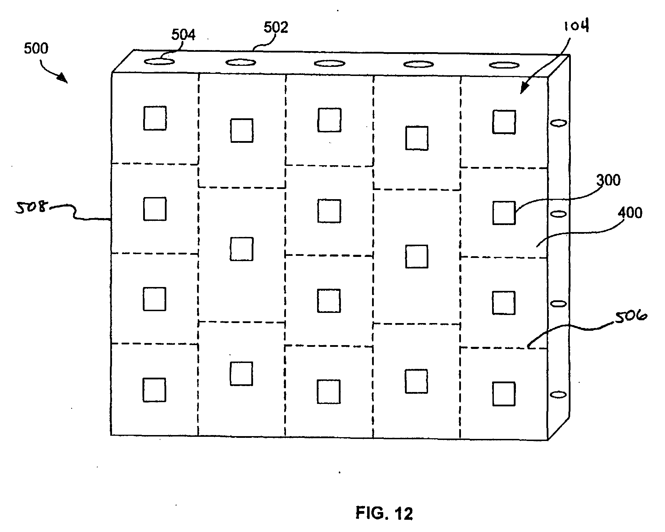

Figure 12 shows an assembly 500 including a support device 502 that supports or houses a patterning array assembly 508 including a plurality of patterning arrays 104. In various embodiments, as described in more detail below, patterning array assembly 508 can have varying numbers of columns, rows, patterning arrays per column, patterning arrays per row, etc., based on a number of desired exposures per pulse, or other implementation design criteria. The patterning arrays 104 can be coupled to a support device 502. Support device 502 can have thermal control areas 504 (e.g., water or air channels, structural heat sinks, etc.). Support device 502 can also have areas for control logic and related circuitry (e.g., see Figure 11 showing elements 116 and element 402, which can be ASICs, A/D converters, D/A converters, fiber optics for streaming data, etc.). In addition, support device 502 can have openings 506 (formed within the dashed shapes) that receive patterning arrays 104, as is known in the relevant art. Support device 502, patterning arrays 104, and all peripheral cooling or control device circuitry are referred to as an assembly.

Assembly 500 can allow for a desired step size to produce the desired stitching (e.g., connecting of adjacent elements of features on object 112) and overlap for leading and trailing patterning arrays 104. A leading patterning array is the patterning array that produces the first image in a series of images on object 112 during a scan, and a trailing patterning array is the patterning array that produces the last image in a series of images on object 112 during a scan. Additional patterning arrays can be present between the leading and trailing patterning arrays. The overlap of the images from the leading and trailing patterning arrays 104 from different scans assists in removing seams that may result from adjacent, non-overlapping scans. Support device 502 can be used for thermal management based on being manufactured from a temperature stable material.

Support device 502 can be utilized as a mechanical backbone to ensure spacing control of patterning arrays 104 and for embedding the circuitry control and the thermal control areas 504. Any electronics can be mounted on either or both of a back side and a front side of support device 502. For example, when using analog-based patterning arrays or electronics, wires can be coupled from control or coupling systems 504 to active areas 300. Based on being mounted on support device 502, these wires can be relatively shorter, which reduces attenuation of analog signals compared to a case where the circuitry is remote from the support device 502. Also, having short links between the circuitry and active areas 300 can increase communication speed, and thus increase pattern readjustment speed in real time.

In some embodiments, when patterning array 104 or electrical devices in the circuitry wear out, assembly 500 can easily be replaced. Although it would appear that replacing assembly 500 is more costly than just a chip on assembly 500, it may in fact be more efficient to replace the entire assembly 500, which can save production costs. Also, assembly 500 can be refurbished, allowing for a reduction in replacement parts if end users are willing to use refurbished assemblies 500. Once assembly 500 is replaced, only an overall alignment is needed before resuming fabrication.

In a lithography system, such as system 100, any optical aberration in the system, such as total focus deviation or other focal aberrations, can result in significant error when the light in the system exposes object 112. Although focal aberrations are used herein as an example, it will be apparent to one of skill in the art that other optical aberrations may also be corrected with the present invention. The optics involved with the aberration may be, for example, patterning array optics 108 or projection optics 110. One method of correcting a focal aberration is to precisely adjust the relative positions of lenses in the optics, such as projection optics 110 or patterning array optics 108. In this way, the flat reticle plane (e.g., the plane of the location of patterning array assembly 508) is projected to a flat object focus plane. However, a lens adjustment may have the negative effect of causing a different aberration that must be corrected by further adjustment of the optics.

In an embodiment of the present invention, focal aberrations are not corrected by moving lenses in the optics. Instead, individual patterning arrays 104 are moved separately from patterning array assembly 508 to change the focus profile of the projected image. This creates a non-flat reticle plane designed to account for errors in the optics, and project onto a flat object focus plane.

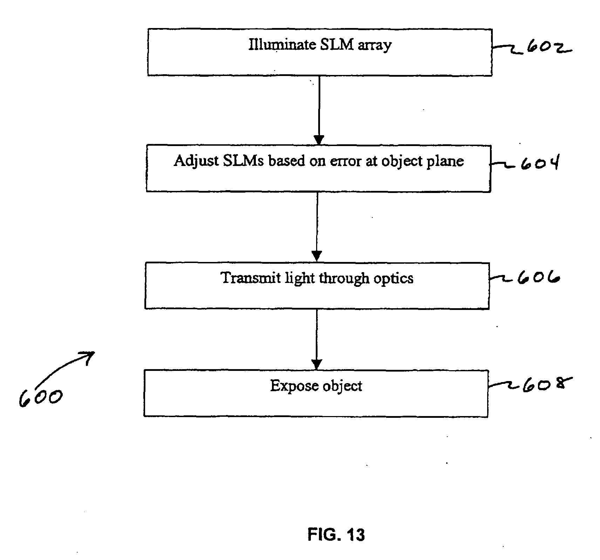

Figure 13 is a flowchart of an example method 600 according to an embodiment of the present invention. In step 602, a patterning array assembly, such as patterning array assembly 508, is illuminated.

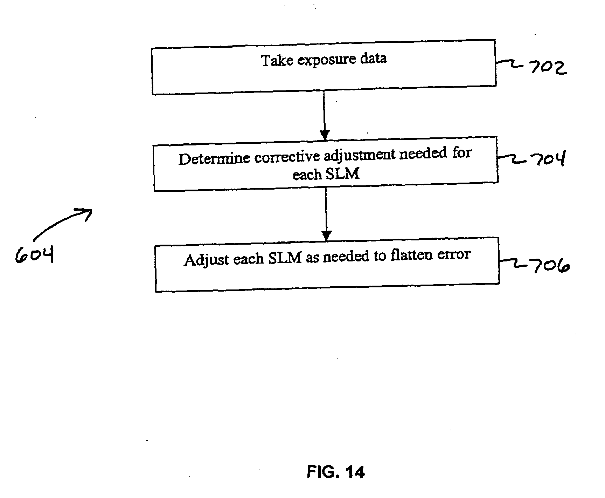

In step 604, the patterning arrays 104 in patterning array assembly 508 are adjusted based on an error or aberration in the exposure at the plane of object 112. Figure 14 is a flowchart further detailing an embodiment of step 604. In step 702, exposure data is taken at the image plane. In an embodiment, exposure data is taken with a series of sensors. In an embodiment, exposure data is taken with a series of measurements by one or more sensors, which move within the exposure beam. For example, a detector moves up and down a slit of the exposure beam to determine points, if any, at which the beam is unfocused. In an embodiment, a test object 112 is exposed and then examined to determine the error or aberration data. In step 704, patterning array adjustments for each patterning array are determined. These adjustments may be required of one or multiple patterning arrays to correct for the aberration in the exposure. After the amount of adjustment is determined in step 704, each patterning array is adjusted in step 706 as needed to flatten or otherwise reduce the aberration.

It is possible that some patterning arrays may need no adjustment. It is also possible that each patterning array will need some form of adjustment. Not every patterning array is required to be adjusted in the same manner as other patterning arrays, if at all. Step 604, and thus method 700, may be performed either before or after step 602.

In step 606 of method 600, after the patterning arrays have been adjusted, light reflected from patterning array assembly 508 is transmitted through the system optics, such as projection optics 110 or patterning array optics 108. In step 608, object 112 is exposed.

Method 600 can be performed upon initial setup of the maskless lithography system. Alternatively or additionally, method 600 can be performed periodically as needed for maintenance of the maskless lithography system. Alternatively, method 600 can also be performed before each exposure performed by the maskless lithography system.

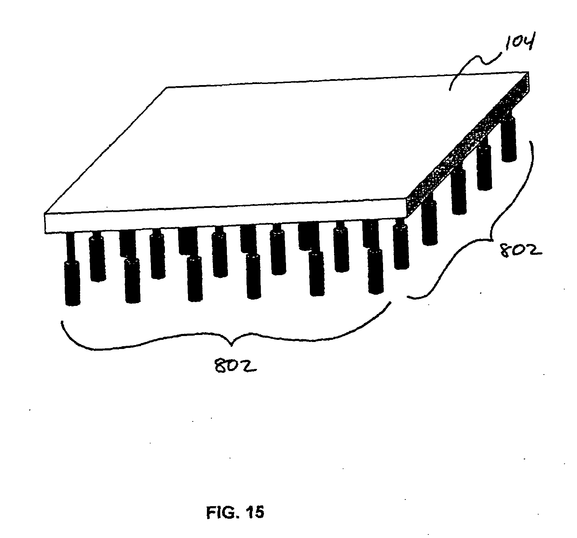

In order to adjust the individual patterning arrays 104, each patterning array 104 in patterning array assembly 508 may be mounted on an adjuster or a plurality of adjusters. Figure 15 is an illustration of an example patterning array 104 according to this embodiment. In an embodiment, a single adjuster is used for each patterning array. In the alternative, as shown in Figure 15, a plurality of adjusters 802 is attached to patterning array 104. Adjusters 802 extend so as to raise and lower parts of the patterning array to which they are attached. In an embodiment, adjusters 802 are active in that they are controlled by, for example, commands from a control system. Active adjusters may include, for example, pistons. The length of active adjusters can be changed during a scan. In an embodiment, adjusters 802 are passive in that they are controlled manually. Passive adjusters may include, for example; screws or bolts whose lengths are manually changed.

In an embodiment of the present invention, each patterning array 104 is mounted in a coplanar arrangement, such as that shown in Figure 12. Although the invention is described according to this initial coplanar arrangement, one of skill in the art will recognize that each patterning array 104 may also be mounted in an initially non-planar arrangement. Individual patterning arrays 104 are then moved out of the coplanar arrangement as needed to correct for optical aberrations, such as total focal deviation, at the image plane. Movement of an individual patterning array 104 is achieved by changing the lengths of various ones of plurality of adjusters 802 that are attached to the patterning array 104.

The movement of patterning array 104 caused by adjusters 802 may be one of a planar movement, a tilting movement, or a bending movement, or it may be any combination of the three movements.

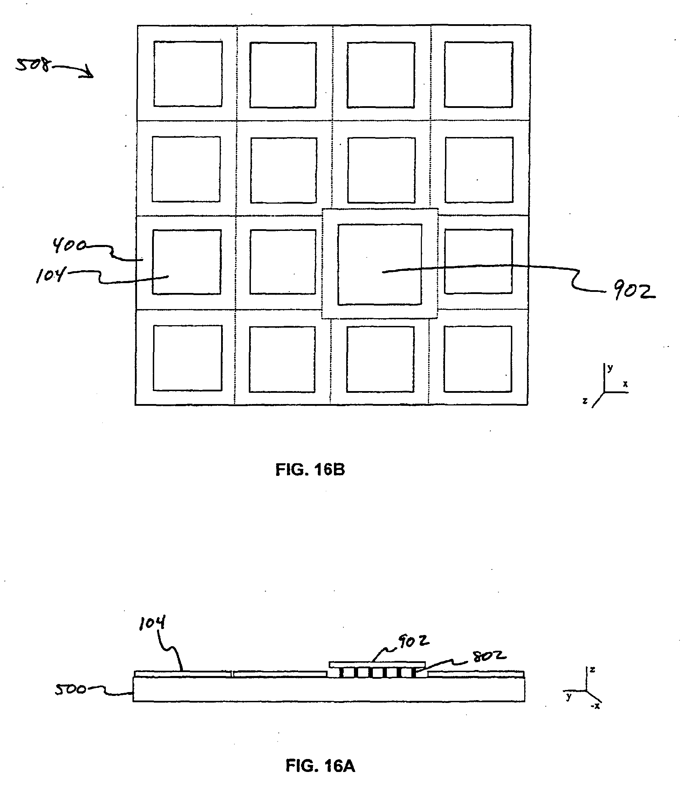

FIGS. 9A and 9B are perspective diagrams showing an embodiment of the present invention. As discussed above with respect to Figure 12, patterning array assembly 508 can have varying numbers of patterning arrays per column and per row, and is not limited by the embodiments particularly described herein. In the example of Figure 16A, patterning array assembly 508 includes 16 patterning arrays 104 surrounded by inactive packaging 400. In this example, each patterning array is the same size, with the rows and columns having an equal number of patterning arrays. Figure 16A is a front view of patterning array assembly 508. Figure 16B is a cross-sectional side view of patterning array assembly 508. In this embodiment, patterning array assembly 508 deviates from a flat plane in that patterning array 902 in patterning array assembly 508 is not coplanar with respect to other patterning arrays 104 in patterning array assembly 508. Instead, plurality of adjusters 802 elevate or de-elevate patterning array 902 to a new plane parallel to the plane of patterning array assembly 508. In this manner, optical aberrations in a particular area of the exposure can be corrected without changing the optics.

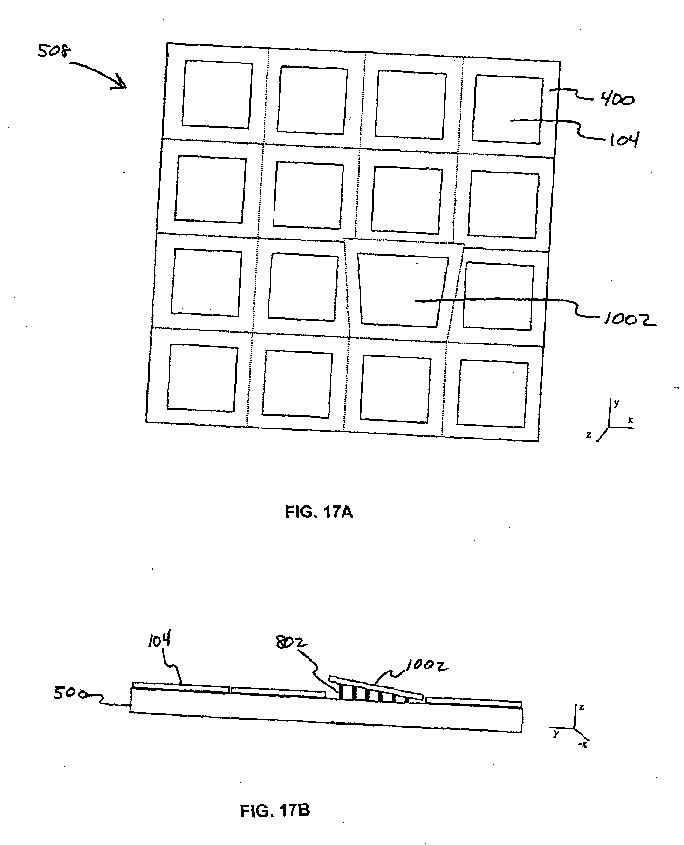

FIGS. 10A and 10B are perspective diagrams showing another embodiment of the present invention. Figure 17A is a front view of patterning array assembly 508. Figure 17B is a cross-sectional side view of patterning array assembly 508. In this embodiment, patterning array assembly 508 deviates from a flat plane in that patterning array 1002 is tilted with respect to the plane of other patterning arrays 104 in patterning array assembly 508. In this example, patterning array 1002 is tilted in the y direction. One of skill in the art will recognize that patterning array 1002 may also be tilted in other directions, such as the x direction. To effect this tilt, plurality of adjusters 802 lengthen in proportion to their respective positions until the desired tilt angle is achieved.

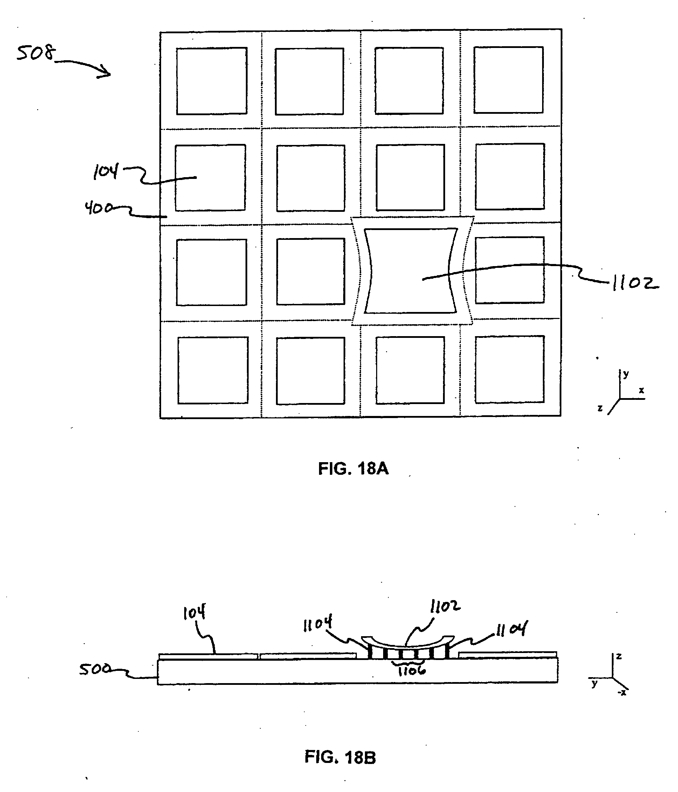

FIGS. 11A and 11B are perspective diagrams showing another embodiment of the present invention. Figure 18A is a front view of patterning array assembly 508. Figure 18B is a cross-sectional side view of patterning array assembly 508. In this embodiment, patterning array assembly 508 deviates from a flat plane in that patterning array 1102 is bent with respect to the plane of other patterning arrays 104 in patterning array assembly 508. In the example of Figure 18B, outer adjusters 1104, in the plurality of adjusters 802, lengthen, while inner adjusters 1106, in the plurality of adjusters 802, lengthen to a lesser extent or otherwise remain short relative to outer adjusters 1104. Each adjuster may have a different length than other adjusters. One of skill in the art will recognize that patterning array 1102 may be bent at a variety of places to achieve the desired result. For example, in an embodiment, patterning array 1102 may be either convex or concave. In an embodiment, patterning array 1102 may be curved on one side and flat on another.

One of skill in the art will recognize that each of the movements described (lifting, tilting, and bending) can be performed either separately or in conjunction with each other. Further, different patterning arrays in patterning array assembly 508 can move differently than other patterning arrays in patterning array assembly 508, depending on the amount of focal correction needed at the locations of the different patterning arrays.

The movement of the individual patterning arrays 104 causes the surface of patterning array assembly 508 to deviate from a flat plane in a controlled and predictable manner. This deliberate deviation from a flat plane changes the focus profile.

Changing the focus profile at the patterning array has several advantages. In systems where focal aberrations are corrected in the system optics, such as, for example, projection optics 110 and patterning array optics 108, the changes may result in other optical aberrations. Subsequent adjustments may again negatively affect the light path. Removing the task of focus correction from projection optics 110 and patterning array optics 108 to patterning arrays 104 decreases the amount of precision corrections that must be made to the optics.

Deviating from a flat plane and correcting for focal aberrations at patterning arrays 104 also allows a less stringent specification for the optics when the system is built. That is, the amount of acceptable error for each lens increases, and the accuracy required of each lens decreases. For example, if an exposure has an overall tolerance of ±100 nm, making adjustments solely in the optical system is both challenging and tedious. However, if the optics are allowed a tolerance of ±500 nm, with the remainder to be corrected by movement of the patterning arrays, the optics are simpler to design. This decrease in accuracy required by the optics saves time in both the manufacturing stage and the setup stage. Thus, the same error tolerance at object 112, formerly required by the optical system, can be achieved with an optical system designed to less strict specifications by using individual patterning arrays 104 to compensate for errors in the optics.

While specific embodiments of the invention have been described above, it will be appreciated that the invention may be practiced otherwise than as described. The description is not intended to limit the invention.

## Claims

1. A lithographic apparatus comprising:

   - an illumination system for supplying a projection beam of radiation;
   - a patterning array of individually controllable elements serving to impart the projection beam with a pattern in its cross-section;
   - a mounting plate on which said patterning array is mounted;
   - a height adjustment structure for locally adjusting the height of the active surface of said patterning array;
   - a substrate table for supporting a substrate;

and

- a projection system for projecting the patterned beam onto a target portion of the substrate.

2. Apparatus according to claim 1 wherein said height adjustment structure comprises a level sensor to detect unflatness in the programmable patterning means and a feedback loop to control the adjustment applied to the patterning array.

3. Apparatus according to claim 1 or 2 wherein said height adjustment structure comprises an array of piezoelectric elements.

4. Apparatus according to claim 1 wherein said height adjustment structure comprises an array of screws or bolts passing through threaded holes in the mounting member and bearing against the patterning array.

5. Apparatus according to claim 1, 2 or 3 comprising a plurality of patterning arrays provided on a common mounting member, and respective height adjustment structures whereby the height adjustment structures enable the various patterning arrays to be mutually leveled.

6. A lithographic apparatus comprising:

- an illumination system for supplying a projection beam of radiation;
- a patterning array of individually controllable elements serving to impart the projection beam with a pattern in its cross-section;
- a substrate table for supporting a substrate; and
- a projection system for projecting the patterned beam onto a target portion of the substrate; wherein
- said patterning array comprises a plurality of active elements disposed on a first surface of a substrate, a second surface of said substrate opposite said first substrate being optically flat; and a rigid mounting body having an optically flat surface to which said second surface of said substrate is bonded.

7. Apparatus according to claim 6 wherein said rigid body is mounted to a mounting plate via a fixed or active mount that is able to correct the global tilt of the patterning arrays.

8. Apparatus according to claim 7 wherein said rigid mounting body is mounted along its neutral line so that the patterning array is not distorted in the event of thermal expansion or contraction of the mounting body.

9. Apparatus according to claim 6, 7 or 8 wherein said second surface of said substrate is bonded to said flat surface of said rigid mounting body by direct crystal bonding ("ansprengen").

10. A device manufacturing method comprising the steps of:

- providing a substrate that is at least partially covered by a layer of radiation sensitive material;
- providing a projection beam of radiation using a radiation system;
- using a patterning array to endow the first projection beam with a pattern in its cross-section;
- projecting the patterned projection beam of radiation onto a target portion of the layer of radiation-sensitive material, and
- mounting the patterning array to a mounting plate or rigid body in such a manner as to ensure the active surface thereof is flat.

11. A device manufacturing method using a maskless lithography system, the method comprising:

illuminating a patterning array assembly having a plurality of patterning arrays, wherein said patterning array assembly defines a first plane; adjusting a position of at least one patterning array in said patterning array assembly from the first plane to a second orientation; and exposing an object with light from the patterning array assembly.

12. The method of claim 11, wherein said first plane is coplanar with at least one other patterning array in the patterning array assembly, and said second orientation is not coplanar with the at least one other patterning array.

13. The method of claim 12, wherein said second orientation is a second plane.

14. The method of claim 13, wherein said second orientation is parallel to said first plane.

15. The method of claim 13, wherein said second orientation is tilted at an angle with respect to said first plane.

16. The method of claim 12, wherein said second orientation is curved with respect to said first plane.

17. The method of any one of claims 11 to 16, wherein the position of said at least one patterning array is adjusted to compensate for focal deviation of the light at said object.

18. The method of any one of claims 11 to 17, wherein the position of said at least one patterning array is adjusted actively.

19. The method of any one of claims 11 to 18, wherein the position of said at least one patterning array is adjusted using pistons.

20. The method of any one of claims 11 to 18, wherein the position of said at least one patterning array is adjusted manually.

21. The method of claim 20, wherein the position of said at least one patterning array is adjusted using screws.

22. The method of any one of claims 11 to 21, wherein said method is performed only during an initial setup of the maskless lithography system.

23. The method of any one of claims 11 to 21, wherein said method is performed periodically for maintenance of the maskless lithography system.

24. A device manufacturing method using a maskless lithography system, comprising:

   illuminating a patterning array assembly having a plurality of patterning arrays, wherein each patterning array in the patterning array assembly has a first position;
   adjusting at least one patterning array from said first position to a second position;
   transmitting light from the patterning array assembly through an optical system; and
   exposing an object with the transmitted light,

   wherein said first position is coplanar with the plurality of patterning arrays in the patterning array assembly, and said second position is not coplanar with the patterning array assembly.

25. The method of claim 24, wherein said second position is parallel to said first position.

26. The method of claim 24, wherein said adjusting step comprises tilting the at least one patterning array.

27. The method of claim 24, wherein said adjusting step comprises bending the at least one patterning array.

28. A device manufacturing method using a maskless lithography system having a plurality of patterning arrays in a patterning array assembly, said patterning array assembly having a reflective surface, said method comprising:

   - adjusting a position of at least one of said plurality of patterning arrays based on said aberration;
   - illuminating said patterning array assembly;
   - transmitting light reflected by said patterning array assembly through an optical system; and
   - exposing an object with said light,
   - wherein said adjusting step causes the reflective surface of said patterning array assembly to deviate from a flat plane.

29. The method of claim 28, wherein said adjusting step comprises:

   - receiving exposure data at a plane of said object;
   - determining corrective adjustment needed for said at least one of said plurality of patterning arrays, wherein said adjustment is based on said exposure data; and
   - adjusting said at least one of said plurality of patterning arrays as needed to reduce said aberration.

30. A maskless lithography system, comprising along a light path:

   an illumination source configured to produce light;
   - a patterning array assembly having a plurality of patterning arrays, each patterning array in the plurality of patterning arrays being attached to a respective adjuster;
   - an optics system configured to condition the light; and
   - an image plane configured to receive the light,
   - wherein each adjuster moves a respective patterning array as needed to correct for an optical aberration in the light received by the object, such that a surface of the patterning array assembly deviates from a flat plane.

31. A system according to claim 30, wherein said aberration is total focus deviation.

32. A system according to claim 30 or 31, wherein each of said adjusters is a set of adjusters.

33. A system according to claim 32, wherein each of said sets of adjusters tilts its respective patterning array.

34. A system according to claim 32, wherein each of said sets of adjusters bends its respective patterning array.

35. A system according to claim 32, wherein each of said sets of adjusters changes an elevation of its respective patterning array.

**36.** A system according to any one of claims 30 to 35, further comprising:

    a controller configured to control said adjusters.

**37.** A system according to claim 36, wherein said adjusters are pistons.

**38.** A system according to claim 32, wherein said adjusters are screws.

Fig. 1

Fig. 2

Fig. 3

Fig. 4

Fig. 5

Fig. 6

| | |
|---|---|
| deposit mirror | S1 |
| polish mirror | S2 |
| polish backside | S3 |
| apply resist | S4 |
| pattern resist & etch | S5 |
| apply protective coating | S6 |
| cut | S7 |
| mount on holding body | S8 |
| remove protective coating | S9 |
| electrical connections | S10 |

Fig. 7

| | |
|---|---|
| deposit mirror | S1 |
| polish mirror | S2 |
| apply resist | S4 |
| pattern resist & etch | S5 |
| apply protective coating | S6 |
| polish backside | S3' |
| cut | S7 |
| mount on holding body | S8 |
| remove protective coating | S9 |
| electrical connections | S10 |

FIG. 8

EP 1 517 188 A2

200

202          214

| Illumination System | | Controller |

204          216

| SLM/ SLM Array | | Controller |

210

| Projection Optics |

212

FIG. 9

FIG. 10

FIG. 11

EP 1 517 188 A2

FIG. 12

```
┌─────────────────────────────────────┐
│         Illuminate SLM array         │───── 602
└─────────────────────────────────────┘
                    │
                    ▼
┌─────────────────────────────────────┐
│  Adjust SLMs based on error at object plane │───── 604
└─────────────────────────────────────┘
                    │
                    ▼
┌─────────────────────────────────────┐
│      Transmit light through optics   │───── 606
└─────────────────────────────────────┘
                    │
                    ▼
┌─────────────────────────────────────┐
│             Expose object            │───── 608
└─────────────────────────────────────┘
```

600

**FIG. 13**

Take exposure data ~702

Determine corrective adjustment needed for each SLM ~704

604

Adjust each SLM as needed to flatten error ~706

FIG. 14

FIG. 15

**FIG. 16B**

**FIG. 16A**

**FIG. 17A**

**FIG. 17B**

FIG. 18A

FIG. 18B